# DEMANDE DE BREVET EUROPEEN

(11) **EP 4 760 412 A1**
(43) Date de publication de la demande: **17.06.2026**
(21) Numéro de dépôt: 24220332.1
(22) Date de dépôt: 16.12.2024
(51) Int. Cl.: G04B 19/12, A44C 27/00, G04B 45/00, C23C 14/00, G02B 5/28, G04B 19/04, C22C 5/02

(54) **COMPOSANT D'HABILLAGE COMPRENANT UN EMPILEMENT DE COUCHES INTERFÉRENTIELLES DE PROTECTION**

(71) Demandeur: The Swatch Group Research and Development Ltd, 2074 Marin (CH)
(72) Inventeur: HALLER, Camille, 1400 Yverdon-les-Bains (CH); CURCHOD, Loïc, 1004 Lausanne (CH); MORADI, Mina, 4600 Olten (CH); BAUDOZ, Marie, 25500 Morteau (CH); POLY, Giovanni, 25140 Charquemont (FR)
(74) Mandataire: ICB SA

(57) **Abrégé**

L'invention concerne un composant d'habillage (10) d'horlogerie, de bijouterie ou de joaillerie, comprenant un substrat (100) présentant une face métallique (101) réalisée dans un métal noble ou dans un alliage de métal noble dont l'indice de réfraction complexe à une longueur d'onde de 550 nm présente une partie réelle n<1 et une partie imaginaire 2<k<3, sur laquelle est déposé un empilement de couches minces diélectriques (110), chacune constituée par une couche mince atomique, formé par au moins une alternance de couches réalisées en TiO₂ et Al₂O₃ et comportant une couche terminale (111) réalisée en TiO₂ et une couche de base (112) reposant sur la face métallique (101) réalisée en TiO₂ ou en Al₂O₃.

## Description

### Domaine technique de l'invention

L'invention relève du domaine de l'horlogerie, de la bijouterie ou de la joaillerie, et concerne plus particulièrement un composant d'habillage d'horlogerie, de bijouterie ou de joaillerie.

Dans le présent texte, les termes « composant d'habillage » désignent, de façon communément admise dans les domaines précités, un composant visible pour un utilisateur, et ayant une fonction notamment décorative, c'est-à-dire contribuant à l'aspect visuel d'un objet.

### Arrière-plan technologique

Dans les domaines de l'horlogerie, de la bijouterie ou de la joaillerie, l'aspect esthétique constitue généralement un objectif majeur.

Dans le domaine horloger par exemple, les composants d'habillage, par exemple les cadrans, permettent, pour une maison horlogère, notamment de se démarquer de ses concurrents, de participer à façonner l'identité d'une marque, et également d'attirer de potentiels clients.

Les cadrans comportent un substrat, généralement réalisé en matériau métallique, par exemple en laiton, ou dans des métaux nobles, tels qu'en or ou en argent. Ces matériaux métalliques sont sujets à la corrosion et/ou au ternissement, d'autant plus s'ils sont sous la forme d'une couche. Afin de protéger le substrat de toute agression chimique, il est généralement recouvert d'une couche de protection sous forme d'un vernis, par exemple du zapon. L'épaisseur de la couche de protection est de l'ordre de plusieurs micromètres, par exemple plus de 10 micromètres, de sorte qu'elle soit suffisamment étanche afin d'obtenir une protection efficace.

Avec une telle épaisseur, la couche de protection atténue l'aspect visuel de toute structuration du substrat ou sa couleur. D'autant plus que, si le substrat présente des structurations, l'épaisseur de la couche de protection doit être davantage augmentée pour être efficace.

### Résumé de l'invention

L'invention résout les inconvénients précités et concerne, à cet effet, un composant d'habillage d'horlogerie, de bijouterie ou de joaillerie, comprenant un substrat présentant une face métallique réalisée dans un métal noble ou dans un alliage de métal noble, sous forme massive ou en couche mince déposée sur ledit substrat, par exemple par dépôt PVD ou galvanique, dont l'indice de réfraction complexe à une longueur d'onde de 550 nm présente une partie réelle n<1 et une partie imaginaire 2<k<3, sur laquelle est déposé un empilement de couches minces diélectriques.

Chacune des couches de l'empilement de couches minces diélectriques est constituée par une couche déposée par une méthode de dépôt ALD, et l'empilement est formé par au moins une alternance de couches réalisées en TiO₂ et Al₂O₃ et comporte une couche terminale réalisée en TiO₂ et une couche de base reposant sur la face métallique du substrat réalisée en TiO₂ ou en Al₂O₃.

L'invention permet avantageusement de garantir la protection chimique et mécanique du composant d'habillage, tout en lui conférant une couleur vive et précise.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, la face métallique du substrat est réalisée en platine ou en alliage de platine.

Dans des modes particuliers de réalisation, la face métallique du substrat est réalisée dans un alliage d'or comprenant 75% en masse d'or, et 25% en masse réparti en argent et/ou en cuivre pour arriver à 100%.

Dans des modes particuliers de réalisation, l'empilement de couches minces diélectriques comporte deux couches, la couche de base étant réalisée en Al₂O₃.

Dans des modes particuliers de réalisation, la couche de base présente une épaisseur comprise entre 1 nm et 10 nm, voire entre 2 nm et 8 nm, et la couche terminale présente une épaisseur comprise entre 10 nm et 30 nm, voire entre 15 nm et 25 nm.

Dans des modes particuliers de réalisation, la face métallique du substrat est réalisée dans un alliage d'or comprenant 75% en masse d'or, de 4,5% à 5,5% en masse d'argent et de 19,5% à 20,5% en masse de cuivre, le totale étant égal à 100%.

Dans des modes particuliers de réalisation, l'l'empilement de couches minces diélectriques comporte trois couches, dont une couche intermédiaire réalisée en Al₂O₃ interposée entre la couche de base et la couche terminale qui sont, elles, réalisées en TiO₂.

Dans des modes particuliers de réalisation, la couche de base et la couche terminale présentent une épaisseur comprise entre 35 nm et 55 nm, voire entre 40 nm et 50 nm, et la couche intermédiaire présente une épaisseur comprise entre 50 nm et 70 nm, voire entre 55 nm et 65 nm.

Dans des modes particuliers de réalisation, la face métallique du substrat est réalisée dans un alliage d'or comprenant 75% en masse d'or, 15% à 16% en masse d'argent et 9% à 10% en masse de cuivre, le total étant égal à 100%.

### Brève description des figures

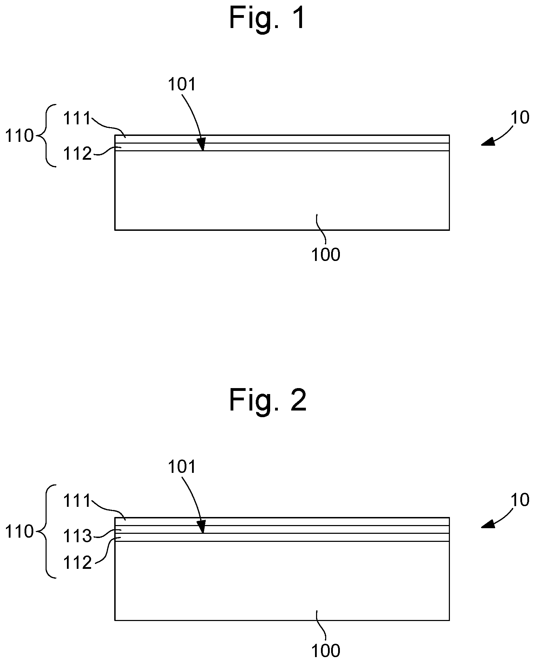

D'autres caractéristiques et avantages de l'invention apparaîtront à la lecture de la description détaillée suivante donnée à titre d'exemple nullement limitatif, en référence aux figures 1 et 2 représentant schématiquement une vue de section d'un composant d'habillage selon deux exemples préférés de réalisation de la présente invention.

On note que les figures ne sont pas dessinées à l'échelle pour des raisons de clarté.

### Description détaillée de l'invention

La présente invention concerne un composant d'habillage 10 d'horlogerie, de bijouterie ou de joaillerie comprenant un substrat 100 présentant une face métallique 101 réalisée dans un métal noble ou dans un alliage de métal noble, c'est-à-dire dans un alliage comprenant au moins 30% en masse de métal noble.

Le composant d'habillage 10 selon l'invention est représenté schématiquement sur les figures 1 et 2 et est particulièrement adapté à former un cadran pour une pièce d'horlogerie, ou toute autre pièce préférentiellement interne de la pièce d'horlogerie.

Le composant d'habillage 10 comporte sur sa face métallique 101, un empilement de couches minces diélectriques 110 semi-transparentes, c'est-à-dire au moins transparent dans le domaine du visible, chacune déposée par une méthode de dépôt de couches minces atomiques connue par l'homme du métier sous l'acronyme « ALD » en langue anglaise pour « Atomic Layer Déposition ». Chaque couche de l'empilement de couches minces diélectriques 110 présente une épaisseur comprise entre quelques nanomètres et quelques dizaines de nanomètres. Cette caractéristique permet à la fois de protéger la face métallique 101 du composant d'habillage 10 contre les agressions chimiques, et de la colorer par effet interférentiel précisément choisi et de façon répétable et robuste. Aussi, l'épaisseur de l'empilement de couches minces diélectriques 110 est homogène et conforme sur l'ensemble de sa surface.

La face métallique 101 peut présenter une structuration, par exemple réalisée par usinage mécanique, par exemple une gravure manuelle ou un usinage avec une machine-outil à commande numérique, par usinage chimique ou au laser. La structuration est formée par des creux et des sommets, la distance entre les creux et les sommets étant, par exemple, égale à au moins 1 µm.

L'empilement de couches minces diélectriques 110 est formé par au moins une alternance de couches réalisées en TiO₂ et Al₂O₃ et comporte une couche terminale 111 réalisée en TiO₂ et une couche de base 112 reposant sur la face métallique 101 réalisée en TiO₂ ou en Al₂O₃.

On comprend ici que la nature de la couche de base 112 dépend du nombre de couches minces diélectriques 110, et en particulier de si le nombre de couches minces diélectriques est pair ou impair.

La couleur interférentielle obtenue par la combinaison de l'empilement de couches minces diélectriques 110 et de la face métallique 101 dépend notamment de l'épaisseur de chaque couche mince diélectrique 110, de leur agencement et de leur nombre, et du matériau constituant la face métallique 101.

En particulier, la présente invention propose un agencement particulier de l'empilement de couches minces diélectriques 110 associé à une face métallique 101 réalisée dans un métal noble ou dans un alliage de métal noble dont l'indice de réfraction complexe à une longueur d'onde de 550 nm présente une partie réelle n<1 et une partie imaginaire 2<k<3.

Avantageusement, grâce au choix de la nature et l'épaisseur des couches de l'empilement de couches minces diélectriques 110 ainsi que du matériau de la face support 101, la couleur interférentielle générée par les caractéristiques de l'invention est très précise.

Dans un exemple particulier de la présente invention, la face métallique 101 est réalisée en or ou en platine, ou en alliage d'un de ces métaux et peut comporter de l'iridium, du palladium, du platine, du rhodium, etc.

En particulier, dans l'exemple de réalisation schématiquement représenté sur la figure 1, l'empilement de couches minces diélectriques 110 comporte deux couches, dont une couche de base 112 réalisée en Al₂O₃.

La couche de base 112 présente une épaisseur comprise entre 1 nm et 10 nm, voire entre 2 nm et 8 nm, et la couche terminale 111 présente une épaisseur comprise entre 10 nm et 30 nm, voire entre 15 nm et 25 nm.

La face métallique 101 est, dans cet exemple de réalisation, réalisée dans un alliage d'or, par exemple comprenant 75% en masse d'or, et 25% en masse répartis en argent et/ou en cuivre pour arriver à 100%, par exemple alliage d'or comprenant 75% en masse d'or, de 4,5% à 5,5% en masse d'argent et de 19,5% à 20,5% en masse de cuivre.

Ainsi, la face métallique 101 présente un indice de réfraction complexe à une longueur d'onde de 550 nm dont la partie réelle n est égale à 0,7 et une partie imaginaire k est égale à 2,5.

La couleur interférentielle obtenue grâce aux paramètres cités, est caractérisée, dans l'espace CIELAB en mode transmission de l'illuminant normalisé D65, avec un observateur de 10° et une géométrie de mesure d:0°, par les paramètres L* = 66, a* = 34, b* = 52 et présente un aspect orange.

Selon un autre exemple de réalisation de la présente invention schématiquement représenté sur la figure 2, l'empilement de couches minces diélectriques 110 comporte trois couches, dont une couche intermédiaire 113 réalisée en Al₂O₃ intercalée entre la couche de base 112 et la couche terminale 111 qui sont, elles, réalisées en TiO₂.

La couche de base 112 et la couche terminale 111 présentent une épaisseur comprise entre 35 nm et 55 nm, voire entre 40 nm et 50 nm, la couche intermédiaire 113 présente une épaisseur comprise entre 50 nm et 70 nm, voire entre 55 nm et 65 nm.

La face métallique 101 est, dans cet exemple de réalisation, réalisée dans un alliage d'or, par exemple comprenant 75% en masse d'or, et 25% en masse répartis en argent et/ou en cuivre pour arriver à 100%, par exemple 15% à 16% en argent et 9% à 10% en cuivre.

Ainsi, la face métallique 101 présente un indice de réfraction complexe à 550 nm de longueur d'onde dont la partie réelle n est égale à 0,4 et une partie imaginaire k est égale à 2,2.

La couleur interférentielle obtenue grâce aux paramètres cités, est caractérisée, dans l'espace CIELAB en mode transmission de l'illuminant normalisé D65, avec un observateur de 10° et une géométrie de mesure d:0°, par les paramètres L* = 76, a* = 21, b* = -27 et présente un aspect rose.

Dans d'autres exemples de réalisation, la face métallique 101 peut être réalisée dans un alliage d'or comprenant 75% en masse d'or, et 12% à 13% en argent et 12% à 13% en cuivre, le total étant égal à 100%.

De manière plus générale, il est à noter que les modes de mise en oeuvre et de réalisation considérés ci-dessus ont été décrits à titre d'exemples non limitatifs, et que d'autres variantes sont par conséquent envisageables.

Notamment, le substrat 100 est formé par un corps sur lequel peut être déposée une couche métallique, par exemple par galvanoplastie, par dépôt physique en phase vapeur, connu par l'homme du métier sous l'acronyme « PVD » en langue anglaise pour « Physical Vapor Déposition » ou par dépôt chimique en phase vapeur, connu par l'homme du métier sous l'acronyme « CVD » en langue anglaise pour « Chemical Vapor Déposition ». La face métallique 101 est alors formée par la couche métallique ainsi déposée. Une telle couche métallique présente alors une épaisseur comprise entre 50 nm et 10 µm, et préférentiellement entre 50 nm et 500 nm.

## Revendications

1. Composant d'habillage (10) d'horlogerie, de bijouterie ou de joaillerie, **caractérisé en ce qu'**il comprend un substrat (100) présentant une face métallique (101) réalisée dans un métal noble ou dans un alliage de métal noble dont l'indice de réfraction complexe à une longueur d'onde de 550 nm présente une partie réelle n<1 et une partie imaginaire 2<k<3, sur laquelle est déposé un empilement de couches minces diélectriques (110), chacune constituée par une couche mince atomique, formé par au moins une alternance de couches réalisées en TiO₂ et Al₂O₃ et comportant une couche terminale (111) réalisée en TiO₂ et une couche de base (112) reposant sur la face métallique (101) réalisée en TiO₂ ou en Al₂O₃.

2. Composant d'habillage (10) selon la revendication 1, dans lequel la face métallique (101) est réalisée en or ou en platine, ou en alliage d'un de ces métaux.

3. Composant d'habillage (10) selon la revendication 2, dans lequel la face métallique (101) est réalisée dans un alliage d'or comprenant 75% en masse d'or, et 25% en masse répartis en argent et/ou en cuivre pour arriver à 100%.

4. Composant d'habillage (10) selon l'une des revendications 1 à 3, dans lequel l'empilement de couches minces diélectriques (110) comporte deux couches, la couche de base (112) étant réalisée en Al₂O₃.

5. Composant d'habillage (10) selon la revendication 4, dans lequel la couche de base (112) présente une épaisseur comprise entre 1 nm et 10 nm, voire entre 2 nm et 8 nm, et la couche terminale (111) présente une épaisseur comprise entre 10 nm et 30 nm, voire entre 15 nm et 25 nm.

6. Composant d'habillage (10) selon la revendication 5, dans lequel la face métallique (101) est réalisée dans un alliage d'or comprenant 75% en masse d'or, de 4,5% à 5,5% en masse d'argent et de 19,5% à 20,5% en masse de cuivre, le total étant égal à 100%.

7. Composant d'habillage (10) selon l'une des revendications 1 à 3, dans lequel l'empilement de couches minces diélectriques (110) comporte trois couches, dont une couche intermédiaire (113) réalisée en Al₂O₃ intercalée entre la couche de base (112) et la couche terminale (111) qui sont, elles, réalisées en TiO₂.

8. Composant d'habillage (10) selon la revendication 7, dans lequel la couche de base (112) et la couche terminale (111) présentent une épaisseur comprise entre 35 nm et 55 nm, voire entre 40 nm et 50 nm, et la couche intermédiaire (113) présente une épaisseur comprise entre 50 nm et 70 nm, voire entre 55 nm et 65 nm.

9. Composant d'habillage (10) selon l'une des revendications 8, dans lequel la face métallique (101) est réalisée dans un alliage d'or comprenant 75% en masse d'or, 15% à 16% en masse d'argent et 9% à 10% en masse de cuivre, le total étant égal à 100%.
